(19) Europäisches Patentamt
European Patent Office
Office européen des brevets

(11) **EP 2 717 301 A1**

(12) **EUROPEAN PATENT APPLICATION**
published in accordance with Art. 153(4) EPC

(43) Date of publication:
**09.04.2014 Bulletin 2014/15**

(51) Int Cl.:
*H01L 21/52* (2006.01)    *C09J 9/02* (2006.01)
*C09J 11/04* (2006.01)    *C09J 201/00* (2006.01)
*H01B 1/00* (2006.01)    *H01B 1/22* (2006.01)
*H01L 21/60* (2006.01)

(21) Application number: **12792349.8**

(22) Date of filing: **29.05.2012**

(86) International application number:
**PCT/JP2012/063729**

(87) International publication number:
**WO 2012/165416 (06.12.2012 Gazette 2012/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.05.2011 JP 2011121444**

(71) Applicant: **Sumitomo Bakelite Co., Ltd.**
**Shinagawa-ku**
**Tokyo 140-0002 (JP)**

(72) Inventors:
• **KANAMORI Naoya**
  **Tokyo 140-0002 (JP)**

• **HARADA Takahiro**
  **Tokyo 140-0002 (JP)**
• **AOKI Chiaki**
  **Tokyo 140-0002 (JP)**
• **MURAYAMA Ryuichi**
  **Tokyo 140-0002 (JP)**

(74) Representative: **Schnappauf, Georg**
**ZSP Patentanwälte**
**Partnerschaftsgesellschaft**
**Radlkoferstrasse 2**
**81373 München (DE)**

(54) **SEMICONDUCTOR DEVICE**

(57) According to the present invention, a semiconductor device having superior electrical conductivity is provided. The semiconductor device (10) of the present invention is provided with a base material (2), a semiconductor element (3), and an adhesive layer (1) that adheres the base material and the semiconductor element while interposed there between. In the adhesive layer (1) of the semiconductor device (10), a metal particle and an insulating particle are dispersed, and the metal particle has flaked shape or ellipsoidal/spherical shape. As the content percentage by volume of the metal particle in the adhesive layer is a and the content percentage by volume of the insulating particles in the adhesive layer is b, the content percentage (a+b) by volume of fillers in the adhesive layer is 0.20 or more and 0.50 or less and the content percentage a/(a+b) by volume of the metal particles in the fillers is 0.03 or more and 0.70 or less.

FIG. 1

EP 2 717 301 A1

**Description**

[Technical Field]

The present invention relates to a semiconductor device prepared using a resin paste. The present application claims priority on the basis of Japanese Patent Application No. 2411-121444, filed in Japan on May 31, 2011, the contents of which are incorporated herein by reference.

[Background Art]

In semiconductor devices, a semiconductor element is fixed through an adhesive layer on a base material such as a lead frame or substrate. This adhesive layer is required to be electrically conductive and thermally conductive in addition to having adhesiveness, and is known to able to be formed by a resin paste containing silver particles. For example, Patent Documents 1 and 2 describe the formation of the aforementioned adhesive layer with a resin paste containing silver particles.

[Citation List]

[Patent Literature]

Patent Document 1: Japanese Unexamined Patent Application, First Publication No. H07-118616
Patent Document 2: Japanese Unexamined Patent Application, First Publication No. H05-89721

[Summary of Invention]

[Problem to be Solved by the Invention]

However, this type of resin paste contains a large number of silver particles for obtaining desired electrical conductivity and thermal conductivity. Since silver particles have a larger specific gravity than the resin component, sedimentation easily occurs during use and storage. Consequently, a resin paste containing a large number of silver particles is poor coating workability and there is a case in which adhesive layer having desired electrical conductivity and thermal conductivity are not stable obtained.

Patent Document 1 describes that sedimentation of silver particles can be suppressed by containing spherical silica having a mean particle diameter of 0.1 $\mu$m to 1.0 $\mu$m in a resin paste in which silver particles are dispersed in a thermosetting resin. However, since spherical silica has insulating properties, there are cases in which the electrical conductivity becomes poor when they are contained in an adhesive layer.

Also, Patent Document 2 describes that an adhesive layer can be controlled to have constant thickness by adding spherical silica, which is controlled to have approximately the same particle diameter as the thickness of the adhesive layer and has a narrow breadth of distribution, to a resin paste in which silver particles are dispersed in a thermosetting resin. However, as well as Patent Document 1, since spherical silica has insulating properties, there are cases in which electrical conductivity becomes poor when spherical silica is contained in an adhesive layer.

In view of the foregoing problems, an object of the present invention is to provide a semiconductor device having superior electrical conductivity.

[Means for Solving the Problem]

The present inventors conducted an intensive study in view of the above problems and discovered an adhesive layer meeting the following conditions has superior electrical conductivity, thereby leading to completion of the present invention.

According to the present invention, a semiconductor device is provided with:

a base material,
a semiconductor element, and
an adhesive layer that adheres the base material and the semiconductor element while interposed there between; wherein,
in the adhesive layer, a metal particle and an insulating particle are dispersed,

the metal particle has a flaked shape or a ellipsoidal/spherical shape, and

as the content percentage by volume of the metal particle in the adhesive layer is a and the content percentage by volume of the insulating particle in the adhesive layer is b, the content percentage (a+b) by volume of fillers in the adhesive layer is 0.20 or more and 0.50 or less and the content percentage a/(a+b) by volume of the metal particle in the fillers is 0.03 or more and 0.70 or less.

Although the reason why the adhesive layer meeting the above conditions develops superior electrical conductivity is not apparent, the following reason is considered. When the content percentage (a+b) by volume of the fillers in the adhesive layer is within the above range, because the surface of the adhesive layer has superior smoothness, the contact resistance of the adhesive layer to the base material or semiconductor element is small which improves the electrical conductivity of the interface of the adhesive layer.

In addition, when the content percentage a/(a+b) by volume of the metal particles in the fillers is within the above range, partial aggregation in the insulating particles occurs and the long axis of the flaked or ellipsoidal/spherical metal particles is aligned so as to be parallel to the direction of gravity due to the aggregation. In the part with no aggregation, the long axis of the metal particles is aligned so as to be perpendicular to the direction of gravity. Thus, the aggregation of the insulating particles makes the parts contacting the parallel direction with the perpendicular direction in the metal particles. Therefore, it is assumed that when the adhesive layer meets the above conditions, superior electrical conductivity can be developed in the thickness direction of the adhesive layer.

[Effects of the Invention]

According to the present invention, a semiconductor device is provided that has superior electrical conductivity.

[Brief Description of Drawings]

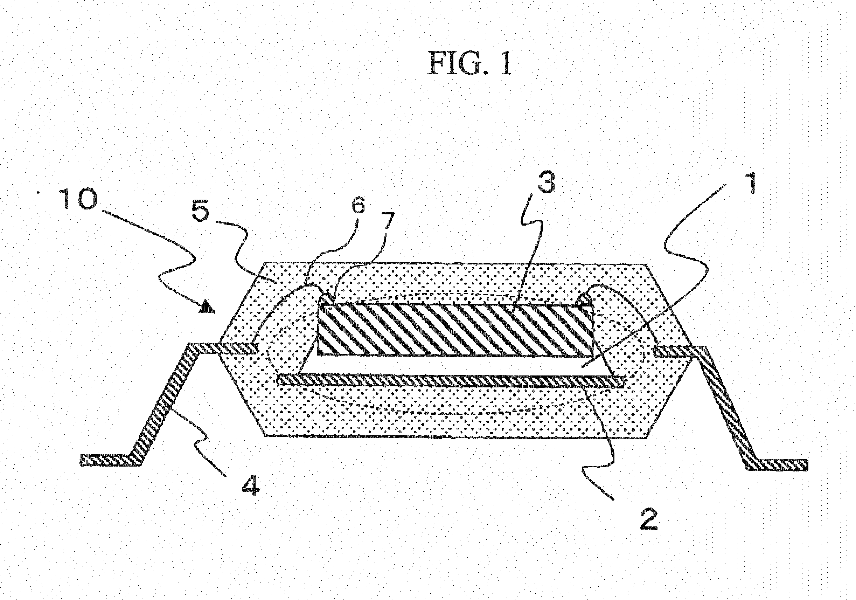

FIG. 1 is a cross-sectional view showing the configuration of a semiconductor device according to the present embodiment.

[Description of Embodiments]

The following provides an explanation of embodiments of the present invention using the drawings. Because the same reference signs are attached to the same features in all drawings, redundant explanations are appropriately omitted.

(Semiconductor Device)

First, the configuration of a semiconductor device according to the present embodiment is explained. Fig.1 is a cross-sectional view showing the configuration of a semiconductor device 10 according to the present embodiment.

According to the present invention, a semiconductor device 10 is provided with a base material 2, a semiconductor element 3, and an adhesive layer 1 that adheres the base material 2 to the semiconductor element 3.

The adhesive layer 1 is formed by compression bonding paste-like resin composition (hereinafter, called "resin paste") including flaked or ellipsoidal/spherical metal particles and an insulating particles with the semiconductor element 3 and the base material 2, and the flaked or ellipsoidal/spherical metal particles and the insulating particles are dispersed in the obtained adhesive layer 1.

In the adhesive layer 1 according to the present embodiment, as the content percentage by volume of the metal particles in the adhesive layer 1 is a and the content percentage by volume of the insulating particles in the adhesive layer 1 is b, the content percentage (a+b) by volume of fillers is 0.20 or more and 0.50 or less, preferably 0.25 or more and 0.45 or less, and more preferably 0.30 or more and 0.40 or less. The fillers in the adhesive layer 1 indicate metal particles and insulating particles. As a result of making the content percentage by volume to be equal to or greater than the lower limit value, the fillers in the adhesive layer 1 are prevented from to being unevenly distributed in the depthwise direction and the contact resistance between adhesive layer I and base material 2 or semiconductor element 3 becomes small. As a result of making the content percentage by volume to be equal to or less than the upper limit value, the interface of the adhesive layer 1 has superior smoothness and the contact resistance between adhesive layer 1 and base material 2 or semiconductor element 3 becomes small.

Also, in the adhesive layer 1 according to the present embodiment, the content percentage a/(a+b) by volume of the metal particles in the fillers is 0.03 or more and 0.70 or less, preferably 0.05 or more and 0.65 or less, and more preferably 0.10 or more and 0.60 or less. As a result of making the content percentage to be equal to or greater than the lower limit value, a conductive network can be formed in the direction to the film thickness.

Moreover, as a result of making the content percentage to be equal to or less than the upper limit value, partial aggregation in the insulating particles occurs and the long axis of the flaked or ellipsoidal/spherical metal particles is aligned so as to be parallel to the direction of gravity due to the aggregation. In the parts with no aggregation, the long axis of the metal particles is aligned so as to be perpendicular to the direction of gravity. Thus, the aggregation of the insulating particles causes the contact parts of the parallel direction and the perpendicular direction in the metal particles to effectively form a conductive network. Therefore, the adhesive layer meeting the above conditions can develop superior electrical conductivity in the thickness direction of the adhesive layer.

The content percentages a and b by volume are values in which the volume occupied by metal particles and volume occupied by insulating particles in the adhesive layer I divided by the entire volume of adhesive layer and are respectively calculated using the following formulas (1) and (2).

$$\text{Content percentage a by volume} = (\text{volume occupied by metal particles})/[(\text{volume occupied by metal particles})+(\text{volume occupied by insulating particles})+(\text{volume occupied by resin component})] \quad (1)$$

$$\text{Content percentage b by volume} = (\text{volume occupied by insulating particles})/[(\text{volume occupied by metal particles})+(\text{volume occupied by insulating particles})+(\text{volume occupied by resin component})] \quad (2)$$

The resin component is a component other than metal particles and insulating particles in adhesive layer 1.

The volume occupied by the resin component is calculated from weight and specific weight excluding metal particles and insulating particles. The specific weight of the resin component uses the specific weight of an adhesive layer, which is produced from the resin paste not including fillers, as the specific weight of the resin component. The volume occupied by the metal particles and the volume occupied by the insulating particles are calculated from weight and true specific weight in the same manner.

The specific weight of the resin component in the adhesive layer may be measured with a buoyancy-type density and specific gravity meter. The true specific weight of metal particles and insulating particles may use the value described in public known documents. When the true specific weight of metal particles and insulating particles are not described in public known documents, it may be calculated, for example, by mixing each of them with a liquid with a specific weight which is known, measuring the specific weight of the mixture with an oscillating-type density and specific gravity meter, and working out between the weight and the volume.

Although there are no particular limitations thereon, thickness of the adhesive layer I is preferably 5 $\mu$m or more and 50 $\mu$m or less and more preferably 10 $\mu$m or more and 40 $\mu$m or less. As a result of making the thickness to be equal to or greater than the lower limit value, greater adhesive strength can be demonstrated. In addition, as a result of making the thickness to be equal to or less than the upper limit value, the electrical conductivity and thermal conductivity can be further improved.

Although there are no particular limitations thereon, examples of the base material 2 include a lead frame such as an alloy 42 lead frame or copper lead frame, an organic substrate such as a glass epoxy substrate (substrate composed of glass fiber-reinforced epoxy resin) or BT substrate (substrate using a BT resin composed of a cyanate monomer and oligomer thereof and bismaleimide), other semiconductor elements, a semiconductor wafer and a spacer. Among these, a lead frame or organic substrate that is able to more effectively demonstrate the electrical conductivity and thermal conductivity of the adhesive layer 1 is preferable. Moreover, the organic substrate is preferably a BGA (ball grid array) substrate.

Although there are no particular limitations, for example, the semiconductor element 3 is preferably a power device with a power consumption of 1.7W or more that is able to more effectively demonstrate electrical conductivity and thermal conductivity of the adhesive layer 1. The semiconductor element 3 is electrically connected to a lead 4 through pads 7 and bonding wires 6. In addition, the periphery of the semiconductor element 3 is sealed by a sealing material layer 5.

(Resin Paste)

Next, a resin paste forming the adhesive layer I is explained. The resin paste according to the present embodiment includes (A) thermosetting resin, (B) metal particles, and (C) insulating particles.

(Thermosetting Resin)

The thermosetting resin (A) is an ordinary thermosetting resin that forms a three-dimensional network structure when heated. Although there are no particular limitations thereon, this thermosetting resin (A) is preferably a material that forms a liquid resin composition, and is preferably a liquid at room temperature. Examples thereof include cyanate resin, epoxy resin, and resins having two or more radical-polymerizable carbon-carbon double bonds in a molecule thereof.

A cyanate resin according to the thermosetting resin (A) is a compound having an -NCO group in a molecule thereof that is a resin that cures by forming a three-dimensional network structure due to reaction of the -NCO group when heated and is a curable multifunctional cyanate compound or a low molecular weight polymer thereof. Examples of cyanate resins according to the thermosetting resin (A) include, but are not limited to, reaction such as 1,3-dicyantobenzene, 1,4-dicyanatobenzene, 1,3,5-tricyanatobenzene, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, 4,4'-dicyanatobiphenyl, bis(4-cyanatophenyl)methane, bis(3,5-dimethyl-4-cyantophenyl)methane, 2,2-bis(4-cyanatophenyl)propane, 2,2-bis(3,5-dibromo-4-cyanatophenyl)propane, bis(4-cyanatophenyl)ether, bis(4-cyanatophenyl)thioether, bis(4-cyanatophenyl)sulfone, tris(4-cyanatophenyl)phosphite or tris(4-cyanatophenyl)phosphate, cyanates obtained by reacting novolac resins and cyanogen halides, and prepolymers having a triazine ring formed by trimerizing a cyanate group of these multifunctional cyanate resins. These prepolymers are obtained by polymerising the aforementioned multifunctional cyanate resin monomers by using as a catalyst an acid such as an organic acid or Lewis acid, a base such as a sodium alcoholate or tertiary amine, or a salt such as sodium carbonate.

Examples of curing accelerators of the cyanate resin according to the thermosetting resin (A) include ordinary known curing accelerators. Examples thereof include, but are not limited to, organometallic complexes such as zinc octylate, tin octylate, cobalt naphthenate, zinc naphthenate or iron acetylacetonate, metal salts such as aluminum chloride, tin chloride or zinc chloride, and amines such as triethylamine or dimethylbenzylamine. One type of these curing accelerators may be used alone or two or more types may be used in combination.

In addition, a cyanate resin can also be used in combination with other resins such as epoxy resin, oxetane resin, or resins having two or more radical-polymerizable carbon-carbon double bonds in a molecule thereof.

An epoxy resin according to the thermosetting resin (A) is a compound having one or more glycidyl groups in a molecule thereof that cures by forming a three-dimensional network structure due to reaction of the glycidyl groups when heated. Although the epoxy resin according to the thermosetting resin (A) preferably contains two or more glycidyl groups in a molecule thereof, this is because reacting a compound containing only one glycidyl group prevents the demonstration of adequate properties by the cured product.

Among epoxy resins according to the thermosetting resin (A), examples of compounds containing two or more glycidyl groups in a molecule thereof include, but are not limited to, bifunctional compounds obtained by epoxidizing bisphenol compounds such as bisphenol A, bisphenol F or biphenol or derivatives thereof, diols having an alicyclic structure such as hydrogenated bisphenol A, hydrogenated bisphenol F, hydrogenated biphenyl, cyclohexanediol, cyclohexanedimethanol or cyclohexanediethanol or derivatives thereof, or aliphatic diols such as butanediol, hexanediol, octanediol, nonanediol or decanediol or derivatives thereof, epoxidized trifunctional compounds having trihydroxyphenylmethane backbone or aminophenyl backbone, and multifunctional compounds obtained by epoxidizing compounds such as phenol novolac resins, cresol novolac resins, phenyl aralkyl resins, biphenyl aralkyl resins or naphthol aralkyl resins. Since the resin composition is preferably a liquid at room temperature, the epoxy resin according to the thermosetting resin (A) is preferably a liquid at room temperature either alone or as a mixture. An example of a method used to epoxidize a diol or derivative thereof consists of reacting two hydroxyl groups of the diol or derivative thereof with epichlorhydrin to convert to glycidyl ether. In addition, a similar method can be used for compounds having three or more functional groups.

A reactive diluent can also be used in the manner in which it is ordinarily used. Examples of reactive diluents include monofunctional aromatic glycidyl ethers and aliphatic glycidyl ethers such as phenyl glycidyl ether, tertiary-butyl phenyl glycidyl ether or cresyl glycidyl ether.

In the case the aforementioned epoxy resin according to the thermosetting resin (A) is used for the thermosetting resin (A), the resin paste in the present embodiment contains a curing agent in order to cure the epoxy resin.

Examples of curing agents of the epoxy resin according to the thermosetting resin (A) include aliphatic amines, aromatic amines, dicyandiamides, dihydrazide compounds, acid anhydrides and phenol resins.

Examples of dihydrazide compounds used as a curing agent of the epoxy resin according to the thermosetting resin (A) include carbonic dihydrazides such as adipic dihydrazide, dodecanoic dihydrazide, isophthalic dihydrazide or p-oxybenzoic dihydrazide.

Examples of acid anhydrides used as a curing agent of the epoxy resin include phthalic anhydride, tetrahydrophthalic anhydride, hexahydrophthalic anhydride, 4-methylhexahydrophthalic anhydride, endomethylene tetrahydrophthalic anhydride, dodecenyl succinic anhydride and maleic anhydride.

A phenol resin used as a curing agent of the epoxy resin according to the thermosetting resin (A) is a compound having two or more phenolic hydroxyl groups in a molecule thereof. Properties of the cured product become poor preventing its use as a result of being unable to adopt a crosslinked structure in the case of a compound having only one phenolic hydroxyl group in a molecule thereof. In addition, although a phenol resin used as a curing agent of the epoxy resin according to the thermosetting resin (A) is required to have two or more phenolic hydroxyl groups in a molecule thereof, it preferably has 2 or more and 5 or less phenolic hydroxyl groups in a molecule thereof, and more preferably has two or three phenolic hydroxyl groups in a molecule thereof. In the case the number of phenolic hydroxyl groups is greater than this, molecular weight becomes excessively high, thereby causing the viscosity of the resin paste to become excessively high, making this undesirable. Examples of such compounds include bisphenols and derivatives thereof such as bisphenol F, bisphenol A, bisphenol S, tetramethyl bisphenol A, tetramethyl bisphenol F, tetramethyl bisphenol S, dihydroxydiphenyl ether, dihydroxybenzophenone, tetramethyl biphenol, ethylidene bisphenol, methylethylidene bis(methylphenol), cyclohexylidene bisphenol or biphenol, trifunctional phenols and derivatives thereof such as tri(hydroxyphenyl)methane or tri(hydroxyphenyl)ethane, and compounds consisting mainly of dikaryons or trikaryons and derivatives thereof obtained by reacting formaldehyde with a phenol such as phenol novolac or cresol novolac.

Although examples of curing accelerators of the epoxy resin according to the thermosetting resin (A) include imidazoles, salts of triphenylphosphine or tetraphenylphosphonium and amine-based compounds such as diazabicycloundecene and salts thereof, imidazole compounds such as 2-methylimidazole, 2-ethylimidazole-2-phenylimidazole, 2-phenyl-4-methylimidazole, 2-phenyl-4-methyl-5-hydroxymethylimidazole, 2-phenyl-4,5-dihydroxymethylimidazole, 2-$C_{11}H_{23}$-imidazole and adducts of 2-methylimidazole and 2,4-diamino-6-vinyltriazine are preferable. Among these, imidazole compounds having a melting point of 180°C or higher are particularly preferable. In addition, the epoxy resin is preferably used in combination with a cyanate resin or resin having two or more radical-polymerizable carbon-carbon double bonds in a molecule thereof.

A resin having two or more radical-polymerizable carbon-carbon double bonds in a molecule thereof according to the thermosetting resin (A) refers to a compound having carbon-carbon double bonds in a molecule thereof that is a resin that cures by forming a three-dimensional network structure as a result of reaction of the carbon-carbon double bonds.

The molecular weight of the thermosetting resin (A) in a resin having two or more radical-polymerizable carbon-carbon double bonds in a molecule thereof according to the thermosetting resin (A) is preferably 500 or more and 50,000 or less. This is because if the molecular weight is lower than the aforementioned range, the elastic modulus of the adhesive layer becomes excessively high, and if the molecular weight is higher than the aforementioned range, viscosity of the resin paste becomes excessively high.

The following indicates preferable examples of resins having two or more radical-polymerizable carbon-carbon double bonds in a molecule thereof, although not limited thereto.

A compound having two or more acrylic groups in a molecule thereof is preferably a polyether, polyester, polycarbonate, poly(meth)acrylate, polybutadiene or a butadiene-acrylonitrile copolymer having two or more acrylic groups in a molecule thereof, having a molecular weight of 500 or more and 50,000 or less.

The polyether is preferably one having repeating organic groups with 3 to 6 carbon atoms bonded through ether bonds, and preferably does not contain an aromatic ring. This is because, in the case of containing an aromatic ring, the compound having two or more acrylic groups in a molecule thereof becomes a solid or highly viscous, and the elastic modulus in the case of obtaining a cured product becomes excessively high. In addition, although the molecular weight of a compound having two or more acrylic groups in a molecule thereof is preferably 500 or more and 50,000 or less as previously described, it is more preferably 500 or more and 5,000 or less and particularly preferably 500 or more 2,000 or less. This is because, if the molecular weight is within the aforementioned ranges, an adhesive layer is obtained that has favorable workability and low elastic modulus. This type of polyether compound having two or more acrylic groups in a molecule thereof can be obtained by reacting a polyether polyol with (meth)acrylic acid or a derivative thereof.

The polyester is preferably that having repeating organic groups having 3 to 6 carbon atoms bonded through ester bonds, and preferably does not contain an aromatic ring. This is because, in the case of containing an aromatic ring, the compound having two or more acrylic groups in a molecule thereof becomes a solid or highly viscous, and the elastic modulus in the case of obtaining a cured product becomes excessively high. In addition, although the molecular weight of a compound having two or more acrylic groups in a molecule thereof is preferably 500 or more and 50,000 or less as previously described, it is more preferably 500 or more and 5,000 or less and particularly preferably 500 or more and 2,000 or less. This is because, if the molecular weight is within the aforementioned ranges, an adhesive layer is obtained that has favorable workability and low elastic modulus. This type of polyester compound having two or more acrylic groups in a molecule thereof can be obtained by reacting a polyester polyol with (meth)acrylic acid or a derivative thereof.

The polycarbonate is preferably that having repeating organic groups having 3 to 6 carbon atoms bonded through carbonate bonds, and preferably does not contain an aromatic ring. This is because, in the case of containing an aromatic ring, the compound having two or more acrylic groups in a molecule thereof becomes a solid or highly viscous, and the elastic modulus in the case of obtaining a cured product becomes excessively high. In addition, although the molecular weight of a compound having two or more acrylic groups in a molecule thereof is preferably 500 or more and 50,000 or less as previously described, it is more preferably 500 or more and 5,000 or less and particularly preferably 500 or more and 2,000 or less. This is because, if the molecular weight is within the aforementioned ranges, an adhesive layer is obtained that has favorable workability and low elastic modulus. This type of polycarbonate compound having two or more acrylic groups in a molecule thereof can be obtained by reacting a polycarbonate polyol with (meth)acrylic acid or a derivative thereof.

The poly(meth)acrylate is preferably a copolymer of (meth)acrylic acid and (meth)acrylate, a copolymer of a (meth)acrylate having a hydroxyl group and a (meth)acrylate not having a polar group, or a copolymer of a (meth)acrylate having a glycidyl group and a (meth)acrylate not having a polar group. In addition, although the molecular weight of a compound having two or more acrylic groups in a molecule thereof is preferably 500 or more and 50,000 or less as previously described, it is more preferably 500 or more and 25,000 or less. This is because, if the molecular weight is within the aforementioned ranges, an adhesive layer is obtained that has favorable workability and low elastic modulus. This type of (meth)acrylate compound having two or more acrylic groups in a molecule thereof can be obtained by reacting with a (meth)acrylate having a hydroxyl group or a (meth)acrylate having a glycidyl group in the case of a copolymer having a carboxyl group, reacting with (meth)acrylic acid or a derivative thereof in the case of a copolymer having a hydroxyl group, or reacting with (meth)acrylic acid or a derivative thereof in the case of a polymer having a glycidyl group.

The polybutadiene can be obtained by reacting polybutadiene having a carboxyl group with a (meth)acrylate having a hydroxyl group or a (meth)acrylate having a glycidyl group, or by reacting polybutadiene having a hydroxyl group with (meth)acrylic acid or a derivative thereof, and can also be obtained by reacting polybutadiene to which maleic anhydride has been added with a (meth)acrylate having a hydroxyl group.

The butadiene-acrylonitrile copolymer can be obtained by reacting a butadiene-acrylonitrile copolymer having a carboxyl group with a (meth)acrylate having a hydroxyl group or a (meth)acrylate having a glycidyl group.

A compound having two or more allyl groups in a molecule thereof is preferably a polyether, polyester, polycarbonate, polyacrylate, polymethacrylate, polybutadiene or butadiene-acrylonitrile copolymer having an allyl group, having a molecular weight of 500 or more and 50,000 or less, and examples thereof include reaction products of diallyl ester compounds, obtained by reacting an allyl alcohol with a dicarboxylic acid in the manner of oxalic acid, malonic acid, succinic acid, glutaric acid, adipic acid, pimelic acid, suberic acid, azelaic acid, sebacic acid, maleic acid, fumaric acid, phthalic acid, tetrahydrophthalic acid or hexahydrophthalic acid and derivatives thereof, and diols in the manner of ethylene glycol, propylene glycol or tetramethylene glycol.

Preferable examples of compounds having two or more maleimide groups in a molecule thereof include bismaleimide compounds such as N,N'-(4,4'-diphenylmethane)bismaleimide, bis(3-ethyl-5-methyl-4-maleimidophenyl)methane or 2,2-bis[4-(4-maleimidophenoxy)phenyl]propane. More preferable examples include compounds obtained by reacting a dimer acid diamine with maleic anhydride, and compounds obtained by reacting a polyol with a maleimidized amino acid in the manner of maleimidoacetic acid or maleimidocaproic acid. Maleimidized amino acids are obtained by reacting maleic anhydride with aminoacetic acid or aminocaproic acid, a polyether polyol, polyester polyol, polycarbonate polyol, polyacrylate polyol or polymethacrylate polyol is preferable for the polyol, and that not containing an aromatic ring is particularly preferable. This is because, in the case of containing an aromatic ring, a compound having two or more maleimide groups in a molecule thereof becomes a solid or highly viscous, and the elastic modulus in the case of obtaining a cured product becomes excessively high.

In addition, the following compounds can be used within a range that does not impair the effects of the thermosetting resin (A) to adjust various properties of the resin past in the present embodiment. Examples thereof include (meth)acrylates having a hydroxyl group, such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, glycerin mono(meth)acrylate, glycerin di(meth)acrylate, trimethylolpropane mono(meth)acrylate, trimethylolpropane di(meth)acrylate, pentaerythritol mono(meth)acrylate, pentaerythritol di(meth)acrylate, pentaerythritol tri(meth)acrylate or neopentyl glycol mano(meth)acrylate, and (meth)acrylates having a carboxyl group obtained by reacting these (meth)acrylates having a hydroxyl group with a dicarboxylic acid or a derivative thereof. Here, examples of dicarboxylic acids that can be used include oxalic acid, malonic acid, succinic acid, glutaric acid, adipic acid, pimelic acid, suberic acid, azelaic acid, sebacic acid, maleic acid, fumaric acid, phthalic acid, tetrahydrophthalic acid, hexahydrophthalic acid and derivatives thereof.

In addition to the compounds described above, examples of other compounds that can be used include methyl (meth)acrylate, ethyl (meth)acrylate, n-butyl (meth)acrylate, isobutyl (meth)acrylate, tertiary-butyl (meth)acrylate, isodecyl (meth)acrylate, lauryl (meth)acrytate, tridecyl (meth)acrylate, 2-ethylhexyl (meth)acrylate, other alkyl (meth)acrylates, benzyl (meth)acrylate, phenoxyethyl (meth)acrylate, glycidyl (meth)acrylate, trimethylolpropane tri(meth)acrylate, zinc mono(meth)acrylate, zinc di(meth)acrylate, dimethylaminoethyl (meth)acrylate, diethylaminoethyl (meth)acrytate, neopentyl glycol (meth)acrylate, trifluoromethyl (meth)acrylate, 2,2,3,3-tetrafluoropropyl (meth)acrylate, 2,2,3,3,4,4-hexafluorobutyl (meth)acrylate, perfluorooctyl (meth)acrylate, perfluorooctylethyl (meth)acrylate, ethylene glycol di(meth)acrylate, propylene glycol di(meth)acrylate, 1,4-butanediol di(meth)acrylate, 1,6-hexanediol di(meth)acrylate, 1,9-nonanediol di(meth)acrylate, 1,3-butanediol di(meth)acrylate, 1,10-decanediol di(meth)acrylate, tetramethylene glycol di(meth)acrylate, methoxyethyl (meth)acrylate, butoxyethyl (meth)acrylate, ethoxydiethylene glycol (meth)acrylate, N,N'-methylenebis(meth)acrylamide; N,N'-ethylenebis(meth)acrylamide, 1,2-di(meth)acrylamide ethylene glycol, di(meth)acryloyloxy methyltricyclodecane, N-(meth)acryloyloxy ethylmaleimide; N-(meth)acryloyloxy ethylhexahydrophthalimide, N-(meth)acryloyloxy ethylphthalimide, n-vinyl-2-pyrrolidone, styrene derivatives and α-methylstyrene derivatives.

Moreover, a thermal radical polymerization initiator is preferably used as a polymerization initiator of a resin having two or more radical-polymerizable carbon-carbon double bonds in a molecule thereof according to the thermosetting resin (A). Although there are no particular limitations on the thermal radical polymerization initiator provided it is normally used as a thermal radical polymerization initiator, it preferably has a decomposition temperature of 40°C or more and 140°C or less in a rapid heating test (decomposition starting temperature when 1 g of sample is placed on an electric heating plate and the temperature is raised at the rate of 4°C/minute). If the decomposition temperature is lower than 40°C, storageability of the resin paste at normal temperatures becomes poor, and if the decomposition temperature exceeds 140°C, curing time becomes extremely long which is undesirable.

Specific examples of thermal radical polymerization initiators that satisfy this requirement include methyl ethyl ketone peroxide, methyl cyclohexanone peroxide, methyl acetoacetate peroxide, acetyl acetone peroxide, 1,1-bis(t-butylperoxy)3,3,5-trimethylcyclohexane, 1,1-bis(t-hexylperoxy)cyclohexane, 1,1-bis(t-hexylperoxy)3,3,5-trimethylcyclohexane, 1,1-bis(t-butylperoxy) cyclohexane, 2,2-bis(4,4-di-t-butylperoxycyclohexyl)propane, 1,1-bis(t-butylperoxy)cyclodecane, n-butyl-4,4-bis(t-butylperoxy)valerate, 2,2-bis(t-butylperoxy)butane,1,1-bis(t-butylperoxy)-2-methylcyclohexane, t-butylhydroperoxide, p-menthanehydroperoxide, 1,1,3,3-tetramethylbutylhydroperoxide, t-hexylhydroperoxide, dicumylperoxide, 2,5-dimethyl-2,5-bis(t-butylperoxy)hexane, α,α'-bis(t-butylperoxy)diisopropylbenzene, t-butylcumylperoxide, di-t-butylperoxide, 2,5-dimethyl-2,5-bis(t-butylperoxy)-3-hexane, isobutyryl peroxide, 3,5,5-trimethylhexanoyl peroxide, octanoyl peroxide, lauroyl peroxide, cinnamoyl peroxide, m-toluyl peroxide, benzoyl peroxide, diisopropyl peroxycarbonate, bis(4-t-butylcyclohexyl)peroxycarbonate, di-3-methoxybutylperoxycarbonate, di-2-ethylhexylperoxycarbonate, di-sec-butylperoxycarbonate, di(3-methyl-3-methoxybutyl)peroxycarbonate, di(4-t-butylcyclohexyl)peroxycarbonate, α,α'-bis(neodecanoylperoxy)diisopropylbenzene, cumylperoxyneodecanoate, 1,1,3,3-tetramethylbutylperoxyneodecanoate, 1-cyclohexyl-1-methylethylperoxyneodecanoate, t-hexylperoxyneodecanoate, t-butylperoxyneodecanoate, t-hexylperoxypivalate, t-butylperoxypivalate, 2,5-dimethyl-2,5-bis(2-ethylhexanoylperoxy)hexane, 1,1,3,3-tetramethylbutylperoxy-2-ethylhexanoate, 1-cyclohexyl-1-methylethylperoxy-2-ethylhexanoate, t-hexylperoxy-2-ethylhexanoate, t-butylperoxy-2-ethylhexanoate, t-butylperoxyisobutyrate, t-butylperoxymaleic acid, t-butylperoxylaurate, t-butylperoxy-3,5,5-trimethylhexanoate, t-butylperoxyisopropyl monocarbonate, t-butylperoxy-2-ethylhexyl monocarbonate, 2,5-dimethy)-2,5-bis(benzoylperoxy)hexane, t-butylperoxyacetate, t-hexylperoxybenzoate, t-butylperoxy-m-tolylbenzoate, t-butylperoxybenzoate, bis(t-butylperoxy) isophthalate, t-butylperoxyallyl monocarbonate and 3,3',4,4'-tetra(t-butylperoxycarbonyl) benzophenone, and these can be used alone or two or more types thereof can be used as a mixture to control curability. In addition, the aforementioned resin having two or more radical-polymerizable carbon-carbon double bonds in a molecule thereof is preferably used in combination with a cyanate resin or epoxy resin.

The incorporated amount of the thermosetting resin (A) is 50% by volume or more and 80% by volume or less, preferably 55% by volume or more and 75% by volume or less, and preferably 60% by volume or more and 70% by volume or less based on 100% by volume of the entire resin paste. As a result of being within these ranges, the workability, heat resistance and the like of the resin paste are even further improved.

(Metal Particles)

Although there are no particular limitations on the metal particles (B) provided they are flaked shaped or ellipsoidal/spherical shaped, they are preferably silver particles since silver particles have superior electrical conductivity and thermal conductivity. In addition to silver, at least one or more types of metals composed of, for example, copper, gold, nickel, palladium, aluminum, tin or zinc, or alloy particles of these metals, can also be used.

Here, silver particles include metal particles in which the surface of metal particles composed of copper, gold, nickel, palladium, aluminum, tin or zinc and the like is coated with silver.

The shape of the metal particles (B) is flaked shape or ellipsoidal/spherical shape. The ellipsoidal/spherical shape means including circular and spherical shape. When the shape of metal particles is flaked shape or ellipsoidal/spherical shape, as described above, the long axis of metal particles can be aligned to be parallel to the direction of gravity due to the insulating particles. In the part with no insulating particles, that of the metal particles can be aligned to be perpendicular to the direction of gravity.

Although there are no particular limitations thereon, the aspect ratio of the metal particles (B) is preferably 1.0 or more and 40.0 or less, more preferably 2.0 or more and 40.0 or less, and most preferably 4.0 or more and 30.0 or less. As a result of making the aspect ratio to be equal to or greater than the lower limit value, the long axis of metal particles (B) can be better aligned so as to be parallel to the direction of gravity

When the aspect ratio exceeds the upper limit value, the workability when mounting the resin paste may decrease which is undesirable.

The aspect ratio of the metal particles (B) is equal to the mean long diameter of the metal particles (B) divided by the mean thickness of the metal particles (B)

The mean long diameter of the metal particles (B) is the mean long diameter among 1000 or more particles in the number-based particle size distribution of the metal particle as determined with a flow-type particle image analyzer. The mean thickness of the metal particles (B) is determined by coating an appropriate amount of the resin paste on a 7mm×7mm silicon tip, mounting a 5mm×5mm silicon tip so that the thickness of the resin paste layer is about 20μm followed by curing at 175°C for 60 minutes, exposing the cross-section of the resin paste by polishing, and measuring the thickness of 50 metal particles (B) by SEM.

In addition, although varying according to the required viscosity of the resin paste, the particle diameter of the metal particles (B) is normally such that the median diameter $d_{50}$ of the metal particles in a number-based particle size distribution as determined with a laser diffraction-scattering type particle size distribution measuring method is preferably 0.3 to 20 μm. If the median diameter $d_{50}$ is less than 0.3 μm, viscosity becomes high, while if the median diameter $d_{50}$ exceeds 20 μm, the resin component easily flows out during coating or curing resulting in bleeding, thereby making this undesirable. In addition, if the median diameter $d_{50}$ exceeds 20 μm, the outlet of a needle may be blocked, thereby preventing long-term continuous use when coating the resin paste with a dispenser.

In addition, the content of ionic impurities such as halogen ions or alkaline metal ions in the metal particles (B) used is preferably 10 ppm or less. Furthermore, the surface of the metal particles (B) used in the present embodiment may be pretreated with a silane coupling agent such as alkoxysilane, acyloxysilane, silazane or organoaminosilane.

In addition, the incorporated amount of the metal particles (B) is preferably 0.6% by volume or more and 35% by volume or less based on 100% by volume of the entire resin paste, and as a result of being within these ranges, favorable thermal conductivity and electrical conductivity can be obtained, and workability is also superior.

If the incorporated amount of metal particles (B) in the resin paste is less than 0.6% by volume, the metal particles (B) may be unable to impart an alignment parallel to the direction of gravity when coated with the thermosetting resin (A), while if the incorporated amount exceeds 35% by volume, the viscosity of the resin paste becomes high and workability decreases, and since a cured product of the resin paste may also become brittle, soldering resistance may decrease which is undesirable.

(Insulating Particles)

There are no particular limitations on the insulating particles (C) and any insulating particles that influence the alignment of the metal particles (B) are can be used. Examples of the insulating particles (C) include inorganic fillers such as silica particles or inorganic fillers such as alumina and organic fillers such as organic polymers.

The insulating particles (C) are preferably able to cause the metal particles (B) contained to align, and in the case of using in semiconductor applications, those having a uniform particle diameter are even more preferable. In addition, the insulating particles (C) are more preferably particles for maintaining a constant thickness of an adhesive layer 1 after curing by imparting a low coefficient of thermal expansion or low coefficient of moisture absorption and the like to the adhesive layer I in the present embodiment.

In addition, although varying according to the required viscosity of the resin paste, the particle diameter of the insulating particles (C) is normally such that the median diameter $d_{50}$ of a number-based particle size distribution of the insulating particles (C) as determined with a laser diffraction-scattering type particle size distribution measuring method is preferably 2 μm or more and 10 μm or less, more preferably 3 μm or more and 8 μm or less, and further more preferably 3 μm or more and 6 μm or less.

When the median diameter $d_{50}$ is less than 2 μm, viscosity becomes high which is undesirable. In addition, if the median diameter $d_{50}$ is 2 μm or more, the long axis of the metal particles (B) becomes parallel to the direction of gravity, thereby enabling them to be aligned more efficiently.

Also, if the median diameter $d_{50}$ exceeds 10 μm, the resin component easily flows out during coating or curing resulting in bleeding which is undesirable. In addition, if the median diameter $d_{50}$ is 10 μm or less, the long axis of the metal particles (B) becomes parallel to the direction of gravity, thereby enabling them to be aligned more efficiently.

Moreover, as the mean long diameter of the metal particles (B) in the number-based particle size distribution of the metal particles as determined with a flow-type particle image analyzer is D, the mean long diameter D of the metal particles (B) and the median diameter $d_{50}$ of the insulating particles (C) preferably meet the relationship of $D \times 0.1 < d_{50} < D \times 2$. When meeting the above relationship, the insulating particles (C) can more effectively influence the alignment of the metal particles (B).

In addition, the incorporated amount of the insulating particles (C) is preferably 6 % by volume or more and 48.5% by volume or less based on 100 % by volume of the entire resin paste, and by the incorporated amount being within this range, favorable thermal conductivity and electrical conductivity can be obtained, while also resulting in superior workability. If the incorporated amount of the insulating particles (C) is less than 6% by volume, the metal particles (B) may be unable to be aligned in parallel with the direction of gravity, and if the incorporated amount exceeds 48.5% by volume, the viscosity of the resin paste becomes high and workability decreases, and since a cured product of the resin paste may also become brittle, soldering resistance may decrease, thereby making this undesirable.

Specific examples of inorganic fillers include aluminum nitride, boron nitride, titanium oxide, silicon carbide, calcium carbonate, silica and alumina. The inorganic filler is preferably able to cause the metal particles (B) to align, and in the case of semiconductor applications, those having a uniform particle diameter are even more preferable. In addition, the inorganic filer is more preferably that for maintaining a constant thickness of the adhesive layer I by imparting a low coefficient of thermal expansion or low coefficient of moisture absorption and the like to the adhesive layer 1. Silica or alumina is particularly preferable.

Specific examples of organic fillers include styrene, styrene/isoprene, styrene/acrylic acid, methyl methacrylate, ethyl acrylate, acrylic acid, ethyl methacrylate, acrylonitrile, methacrylate, divinylbenzene, n-butylacrylate, nylon, silicone, urethane, melamine, cellulose, cellulose acetate, chitosan, acrylic rubber/methacrylate, ethylene, ethylene/acrylic acid, polypropylene or benzoguanamine, phenol, fluorine and vinylidene fluoride polymers.

The organic filler is preferably one which is able to cause the metal particles (B) to align, and in the case of semiconductor applications, one having a uniform particle diameter is even more preferable. In addition, the inorganic filer is more preferably that for maintaining a constant thickness of the adhesive layer 1 by imparting a low coefficient of thermal expansion or low coefficient of moisture absorption and the like to the adhesive layer 1. Crosslinked organic polymers composed mainly of poly(methyl methacrylate) are particularly preferable.

The resin paste in the present embodiment preferably further contains a coupling agent such as a silane coupling agent in the manner of epoxysilane, mercaptosilane, aminosilane, alkylsilane, ureidosilane or vinylsilane, a titanate coupling agent, an aluminum coupling agent or an aluminum/zirconium coupling agent.

Other additives may also be used in the resin paste in the present embodiment as necessary. Examples of other additives include colorants such as carbon black, low stress components such as silicone oil or silicone rubber, inorganic ion exchangers such as hydrotalcite, antifoaming agents, surfactants, various types of polymerization inhibitors and antioxidants, and these various additives may be suitably incorporated.

In addition, organic compounds can also be added to the resin paste in the present embodiment as necessary within a range that does not have an effect on the alignment of the metal particles (B) when in the form of a cured product. Examples thereof include hexane, 2-methylpentane, 2,2-dimethylbutane, 2,3-dimethylbutane, heptane, octane, 2,2,3-trimethylpentane, isooctane, nonane, 2,2,5-trimethylhexane, decane, 1-hexene, 1-heptene, 1-octane, 1-nonene, 1-decene, ethylbenzene, cumene, mesitylene, butylbenzene, p-cymene, diethylbenzene, methylcyclopentane, cyclohexane, methylcyclohexane, ethylcyclohexane, p-menthane, cyclohexene, $\alpha$-pinene; dipentene, decaline, methanol, ethanol, 1-propanol, 2-propanol, 1-butanol, 2-butanol, isobutyl alcohol, tert-butyl alcohol, 1-pentanol, 2-pentanol, 3-pentanol, 2-methyl-1-butanol, isopentyl alcohol, tert-pentyl alcohol, 3-methyl-2-butanol, neopentyl alcohol, 1-hexanol, 2-methyl-1-pentanol, 4-methyl-2-pentanol, 2-ethyl-1-butanol, 1-heptanol, 2-heptanol, 3-heptanol, 1-octanol, 2-octanol, 2-ethyl-1-hexanol, 3,5,5-trimethyl-1-hexanol, cyclohexanol, 1-methylcyclohexanol, 2-methylcyclohexanol, 3-methylcyclohexanol, 4-methylcyclohexanol, abietinol, 1,2-ethanediol, 1,2-propanediol, 1,2-butanediol, 2-methyl-2,4-pentanediol, dipropyl ether, diisopropyl ether, dibutyl ether, anisole, phenetole, methoxytoluene, benzyl ethyl ether, 2-methylfuran, tetrahydrofuran, tetrahydropyran, 1,2-dimethoxyethane, 1,2-diethoxyethane, diethylene glycol dimethyl ether, diethylene glycol diethyl ether, acetal, acetone, methyl ethyl ketone, 2-pentanone, 3-pentanone, 2-hexanone, methyl isobutyl ketone, 2-heptanone, 4-heptanone, diisobutyl ketone, acetonitrile acetone, mesityl oxide, phorone, cyclohexanone, methylcyclohexanone, propionic acid, butyric acid, isobutyric acid, pivalic acid, valeric acid, isovaleric acid, 2-ethylbutyric acid, propionic anhydride, butyric anhydride, ethyl formate, propyl formate, butyl formate, isobutyl formate, pentyl formate, methyl acetate, ethyl acetate, propyl acetate, isopropyl acetate, butyl acetate, isobutyl acetate, sec-butyl acetate, pentyl acetate, isopentyl acetate, 3-methoxybutyl acetate, sec-hexyl acetate, 2-ethylbutyl acetate, 2-ethylhexyl acetate, cyclohexyl acetate, methyl propionate, ethyl propionate, butyl propionate, isopentyl propionate, methyl butyrate, ethyl butyrate, butyl butyrate, isopentyl butyrate, isobutyl isobutyrate, ethyl 2-hydroxy-2-methyl propionate, ethyl isovalerate, isopentyl isovalerate, methyl benzoate, diethyl oxalate, diethyl malonate, ethylene glycol monoacetate, ethylene diacetate, monoacetin, diethyl carbonate, nitromethane, nitroethane, 1-nitropropane, 2-nitropropane, acetonitrile, propionitrile, butyronitrile, isobutyronitrile, valeronitrile, benzonitrile, diethylamine, triethylamine, dipropylamine, diisopropylamine, dibutylamine, diisobutylamine, aniline, N-methylaniline, N,N-dimethylaniline, pyrrole, piperidine, pyridine, $\alpha$-picoline, $\beta$-pi-

coline, γ-picoline, 2,4-lutidine, 2,6-lutidine, N-methylformamide, N,N-dimethylformamide, N,N-diethylformamide, N,N-dimethylacetoamide, dimethylsulfoxide, 2-methoxymethanol, 2-ethoxymethanol, 2-(methoxymethoxy)ethanol, 2-isopropoxyethanol, 2-butoxyethanol, 2-(thiopentyloxy)ethanol, furfuryl alcohol, tetrahydrofurfuryl alcohol, diethylene glycol monomethyl ether, 1-methoxy-2-propanol, 1-ethoxy-2-propanol, dipropylene glycol monomethyl ether, dipropylene glycol monoethyl ether, diacetone alcohol, 2-(dimethylamino)ethanol, 2-(diethylamino)ethanol, morpholine, N-ethylmorpholine, methyl lactate, ethyl lactate, butyl lactate, pentyl lactate, 2-methoxyethyl acetate, 2-ethoxyethyl acetate, 2-butoxyethyl acetate, methyl acetoacetate and ethyl acetoacetate. These can be used without any particular limitations, and two or more types may be used in combination.

The resin paste in the present embodiment can be produced by, for example, preliminarily mixing each component followed by kneading using a 3-roll roller and degassing in a vacuum.

(Semiconductor Device)

A method for manufacturing the semiconductor device 10 using the resin paste according to the present embodiment can use commonly known methods. For example, after coating the resin paste at a prescribed site on the base material 2 by dispensing using a commercially available die bonder, the semiconductor element 3 is mounted followed by heat-curing to form the adhesive layer I. Subsequently, wire bonding is carried out followed by forming the sealing material layer 5 using an epoxy resin to manufacture the semiconductor device 10.

[Examples]

Although the following indicates specific examples relating to the present embodiment, the present invention is not limited thereto. Each of the resin paste components indicated below are used in the present examples.

As a thermosetting resin (A), Bisphenol F epoxy resin (Nippon Kayaku Co., Ltd., RE-403S) and Diallyl Ester Resin: (Showa Denko K.K., DA-101) were used.

As a curing agent, Dicyandiamide (Adeka Corp., ADEKA HARDNENER EH-3636AS) was used.

As a curing accelerator, 2-phenyl-4-methyl-5-hydroxymethylimidazole (Shikoku Chemicals Corp., Curazol 2P4MHZ) was used.

As a polymerization initiator, 1,1-di(t-butylperoxy)cyclohexane (NOF CORPORATION, PERHEXA C(S)) was used.

As an epoxy diluent, tertiary-butyl phenyl glycidyl ether (Nippon Kayaku Co., Ltd., TGE-H) was used.

As an acrylic diluent, ethylene glycol dimethacrylate(Kyoeisha Chemical Co., Ltd., Light Ester EG) was used.

As a coupling agent, bis(trimethoxysilylpropyl)tetrasulfide (Daiso Co., Ltd., Cabrus 4) was used.

As metal particles (B), silver particles 1 (Fukuda Metal Foil & Powder Co., Ltd., Agc-GS, median diameter $d_{50}$: 8.0 μm, aspect ratio: 4.1, mean long diameter: 4.6μm) was used.

As metal particles (B), silver particles 2(TOKURIKI CHEMICAL RESEARCH CO., Ltd., TC-101, median diameter $d_{50}$: 8.0 μm, aspect ratio: 16.4, mean long diameter: 4.6μm) was used.

As insulating particles (C), silica particles A (MRC UNITEC Co., Ltd., QS-4F2, median diameter $d_{50}$: 4.2 μm), silica particles B (Admatechs Company Limited, SO-E2-24C, median diameter $d_{50}$: 0.6 μm), silica particles C (Nippon Aerosil Co., Ltd., R-805, median diameter $d_{50}$: 0.05 μm), alumina particles (Nippon Steel & Sumikin Materials Co., Ltd. Micron Co., DAW-10, median diameter $d_{50}$: 10 μm), and organic polymer (NIPPON SHOKUBAI CO., LTD, MA-1004, median diameter $d_{50}$: 5 μm) were used.

[Examples 1 to 11 and Comparative Examples 1 to 4]

The aforementioned components were blended in the ratios shown in Table 1 followed by kneading with a 3-roll roller and degassing for 15 minutes at 2 mmHg in a vacuum chamber to produce each resin paste. Blending ratios are in parts by weight.

(Evaluation Tests)

The following evaluation tests were carried out on each of the resin paste obtained in the manner described above. The evaluation results are shown in Table 1.

(Viscosity)

Values were measured at 25°C and 2.5 rpm using a type E viscometer (3° cone) immediately after producing the aforementioned resin pastes. When the viscosity measured immediately after producing the resin paste was within the range of 10 Pa s or more and 50 Pa s or less, it was evaluated as O, and when the viscosity was outside the range, it was evaluated as X.

(Volume Resistivity)

In order to measure the connection resistance, the resin paste was inserted between a copper frame and a copper frame coated with Ag and was cured in oven at 175°C for 60 minutes. After curing, the electric resistance value of the sample in which the inserted resin paste was measured by a resistivity measuring device to calculate volume resistivity in the perpendicular (thickness) direction with the connection distance and the connection area. When the volume resistivity in perpendicular (thickness) direction was $1.0 \times 10^{-1}$ $\Omega \cdot$cm or less, it was evaluated as O, and when the volume resistivity exceeds $1.0 \times 10^{-1}$ $\Omega \cdot$cm, it was evaluated as X.

(Content Percentages by volume of each components in adhesive layer)

The content percentages a and b by volume are values in which the volume occupied by metal particles and volume occupied by insulating particles in the adhesive layer 1 divided by the entire volume of adhesive layer and are respectively calculated using the following formula (I) and (2).

$$\text{Content percentage a by volume} = (\text{volume occupied by metal particles})/[(\text{volume occupied by metal particles})+(\text{volume occupied by insulating particles})+(\text{volume occupied by resin component})] \quad (1)$$

$$\text{Content percentage b by volume} = (\text{volume occupied by insulating particles})/[(\text{volume occupied by metal particles})+(\text{volume occupied by insulating particles})+(\text{volume occupied by resin component})] \quad (2)$$

The resin component is a component other than metal particles and insulating particles in adhesive layer.
The volume occupied by the resin component was calculated from weight and specific weight excluding metal particles and insulating particles. The specific weight of the resin component used the specific weight of an adhesive layer as the specific weight of the resin component, in which an adhesive layer was produced from the resin paste not including fillers and the specific weight of the adhesive layer was measured with flow-type density and specific gravity meter. The volume occupied by the metal particles and the volume occupied by the insulating particles are calculated from weight and true specific weight in the same manner. The true specific weights of the metal particles and insulating particles referred to common documents.
[Table 1]

Table 1

| | Example 1 | Example 2 | Example 3 | Example 4 | Example 5 | Example 6 | Example 7 | Example 8 | Example 9 | Example 10 | Example 11 | Comparative Example 1 | Comparative Example 2 | Comparative Example 3 | Comparative Example 4 |
|---|---|---|---|---|---|---|---|---|---|---|---|---|---|---|---|
| Blend (weight part) | | | | | | | | | | | | | | | |
| Thermosetting resin(A)+Additives | | | | | | | | | | | | | | | |
| Epoxy Resin | 20,5 | 26,6 | 22,1 | 17,6 | 20,5 | | 11,6 | 17,9 | 23,0 | 15,0 | 20,5 | 15,7 | 30,3 | 29,9 | 22,8 |
| Diallyl Ester Resin | | | | | | 19,3 | 7,7 | | | 10,0 | | | | | |
| Curing Agent | 0,3 | 0,4 | 0,3 | 0,2 | 0,3 | | 0,2 | 0,2 | 0,3 | 0,2 | 0,3 | 0,2 | 0,4 | 0,4 | 0,4 |
| Curing Accelerator | 0,3 | 0,4 | 0,3 | 0,2 | 0,3 | | 0,2 | 0,2 | 0,3 | 0,2 | 0,3 | 0,2 | 0,4 | 0,4 | 0,4 |
| Polymerization Initiator | | | | | | 0,3 | 0,2 | | | 0,2 | | | | | |
| Epoxy Diluent | 6,8 | 8,9 | 7,4 | 5,9 | 6,8 | | 3,9 | 6,0 | 7,7 | 5,0 | 6,8 | 5,2 | 10,1 | 10,0 | 7,6 |
| Acrylic Diluent | | | | | | 8,3 | 4,6 | | | 6,0 | | | | | |
| Coupling Agent | 0,8 | 1,1 | 0,9 | 0,7 | 0,8 | 0,8 | 0,5 | 0,7 | 0,9 | 0,6 | 0,8 | 0,6 | 1,2 | 1,2 | 0,9 |
| | | | | | | | | | | | | | | | |
| SUM | 28,7 | 37,2 | 30,9 | 24,6 | 28,7 | 28,7 | 28,7 | 25 | 32,2 | 37,2 | 28,7 | 22 | 42,4 | 41,8 | 32,1 |
| | | | | | | | | | | | | | | | |
| Metal Particles (B) | | | | | | | | | | | | | | | |
| Silver Particles 1 | 60 | 30 | 62 | 55 | 60 | 60 | 60 | 60 | 60 | | 60 | 40 | 50 | 5 | 63,3 |
| Silver Particles 2 | | | | | | | | | | 30 | | | | | |
| | | | | | | | | | | | | | | | |
| Insulating Particles (C) | | | | | | | | | | | | | | | |
| Silica A (4.2µm) | 11,3 | 32,8 | 7,1 | | 10 | 11,3 | 11,3 | | | 32,8 | 0,6 | 38 | 7,6 | 53,2 | 4,6 |
| Silica B(0.6µm) | | | | 20,4 | | | | | | | | | | | |
| Silica C(0.05µm) | | | | | 1,3 | | | | | | 10,7 | | | | |
| Alumina (10µm) | | | | | | | | | 15 | | | | | | |
| Organic Polymer(5µm) | | | | | | | | | | 7,8 | | | | | |
| | | | | | | | | | | | | | | | |
| (a+b) | 0,30 | 0,35 | 0,25 | 0,40 | 0,30 | 0,30 | 0,30 | 0,30 | 0,30 | 0,35 | 0,30 | 0,52 | 0,18 | 0,40 | 0,21 |
| a/(a+b) | 0,53 | 0,16 | 0,65 | 0,36 | 0,53 | 0,53 | 0,53 | 0,60 | 0,47 | 0,16 | 0,53 | 0,18 | 0,58 | 0,02 | 0,75 |
| | | | | | | | | | | | | | | | |
| Evaluation Results | | | | | | | | | | | | | | | |
| Viscosity(Pa·s) | 18 | 30 | 14 | 36 | 22 | 17 | 25 | 15 | 19 | 25 | 56 | 72 | 7 | 27 | 11 |
| Volume Resistivity(Ω·cm) | $1.0 \times 10^{-2}$ | $8.0 \times 10^{-2}$ | $8.0 \times 10^{-3}$ | $7.0 \times 10^{-2}$ | $1.0 \times 10^{-2}$ | $6.0 \times 10^{-2}$ | $3.0 \times 10^{-2}$ | $6.0 \times 10^{-2}$ | $5.0 \times 10^{-2}$ | $4.0 \times 10^{-2}$ | $9.0 \times 10^{-2}$ | $8.0 \times 10^{-1}$ | $12.0 \times 10^{-1}$ | $9.0 \times 10^{-1}$ | $20.0 \times 10^{-1}$ |
| Comprehensive Evaluation | O | O | O | O | O | O | O | O | O | O | O | X | X | X | X |

EP 2 717 301 A1

As evidenced by Table 1, the resin pastes of Examples 1 to 11 have viscosities within the approximately suitable range and have superior workability. Also, the adhesive layers formed using the resin paste of Examples 1 to 11 have low volume resistivity and superior electrical conductivity.

[Industrial Applicability]

According to the present invention, the present invention is extremely industrially useful since it provides a resin composition having superior electrical conductivity.

[Reference Sign List]

1 Adhesive layer
2 Base material
3 Semiconductor element
4 Lead
5 Sealing material layer
6 Bonding wire
7 Pad
10 Semiconductor device

**Claims**

1. A semiconductor device is provided with:

   a base material,
   a semiconductor element, and
   an adhesive layer that adheres the base material and the semiconductor element while interposed there between; wherein,
   in the adhesive layer, a metal particle and an insulating particle are dispersed,
   the metal particle has flaked shape or ellipsoidal/spherical shape, and
   as the content percentage by volume of the metal particle in the adhesive layer is a and the content percentage by volume of the insulating particle in the adhesive layer is b,
   the content percentage (a+b) by volume of filler in the adhesive layer is 0.20 or more and 0.50 or less and
   the content percentage a/(a+b) by volume of the metal particle in the filler is 0.03 or more and 0.70 or less.

2. A semiconductor device according to Claim 1, wherein the median diameter $d_{50}$ of the metal particle in a number-based particle size distribution as determined with a laser diffraction-scattering type particle size distribution measuring method is $2\mu$m or more and $10\mu$m or less.

3. A semiconductor device according to Claim 1 or 2, wherein, when the mean long diameter of the metal particle in the number-based particle size distribution as determined with a flow-type particle image analyzer is D, $D\times0.1<d_{50}<D\times2$.

4. A semiconductor device according to any one of Claims 1 to 3, wherein the insulating particle includes one or more kinds selected from silica particle, alumina, and organic polymer.

5. A semiconductor device according to any one of Claims 1 to 4, wherein the metal particle includes a silver particle.

6. A semiconductor device according to Claim 5, wherein the silver particle includes a metal particle covered with silver.

7. A semiconductor device according to any one of Claims 1 to 6, wherein the base material is a lead frame or BGA substrate.

8. A semiconductor device according to any one of Claims I to 7, wherein the semiconductor element is a power device with a power consumption of 1.7W or more.

FIG. 1

<table>
<tr><td colspan="2" align="center">**INTERNATIONAL SEARCH REPORT**</td><td>International application No.<br>PCT/JP2012/063729</td></tr>
</table>

| | |
|---|---|
| A. CLASSIFICATION OF SUBJECT MATTER<br>*H01L21/52*(2006.01)i, *C09J9/02*(2006.01)i, *C09J11/04*(2006.01)i, *C09J201/00*<br>(2006.01)i, *H01B1/00*(2006.01)i, *H01B1/22*(2006.01)i, *H01L21/60*(2006.01)i | |

According to International Patent Classification (IPC) or to both national classification and IPC

| B. FIELDS SEARCHED |
|---|
| Minimum documentation searched (classification system followed by classification symbols)<br>H01L21/52, C09J9/02, C09J11/04, C09J201/00, H01B1/00, H01B1/22, H01L21/60 |

| Documentation searched other than minimum documentation to the extent that such documents are included in the fields searched |
|---|
| Jitsuyo Shinan Koho    1922–1996   Jitsuyo Shinan Toroku Koho   1996–2012<br>Kokai Jitsuyo Shinan Koho  1971–2012   Toroku Jitsuyo Shinan Koho   1994–2012 |

| Electronic data base consulted during the international search (name of data base and, where practicable, search terms used) |
|---|
| |

C. DOCUMENTS CONSIDERED TO BE RELEVANT

| Category* | Citation of document, with indication, where appropriate, of the relevant passages | Relevant to claim No. |
|---|---|---|
| X | JP 7-211145 A (Minnesota Mining and Manufacturing Co.),<br>11 August 1995 (11.08.1995),<br>paragraphs [0007] to [0011], [0017]; tables 1 to 4<br>& EP 734576 A       & WO 1995/016998 A1<br>& DE 69427037 D     & CN 1137324 A | 1,3,5-8 |
| A | JP 2010-87235 A (Sumitomo Bakelite Co., Ltd.),<br>15 April 2010 (15.04.2010),<br>paragraphs [0020] to [0026]<br>(Family: none) | 1-8 |
| A | JP 7-118616 A (Sumitomo Bakelite Co., Ltd.),<br>09 May 1995 (09.05.1995),<br>paragraphs [0007] to [0009]<br>(Family: none) | 1-8 |

| ☒ Further documents are listed in the continuation of Box C. | ☐ See patent family annex. |
|---|---|

| | |
|---|---|
| *   Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>28 August, 2012 (28.08.12) | Date of mailing of the international search report<br>11 September, 2012 (11.09.12) |
|---|---|
| Name and mailing address of the ISA/<br>   Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2012/063729 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2-269172 A (E.I. Du Pont De Nemours & Co.), 02 November 1990 (02.11.1990), page 4, upper left column, line 15 to page 6, upper left column, line 20<br>& US 4906596 A        & EP 317694 A1<br>& DE 3882920 A        & HK 27394 A<br>& CA 1324859 A        & SG 19494 G<br>& KR 10-1991-0003851 B  & DK 54988 A0 | 1-8 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2411121444 B
- JP H07118616 B

- JP H0589721 B